# EUROPEAN PATENT SPECIFICATION

(11) **EP 2 416 374 B1**
(45) Date of publication and mention of the grant of the patent: **16.06.2021**
(21) Application number: 09842733.9
(22) Date of filing: 09.07.2009
(51) Int. Cl.: H01L 31/048

(54) **SOLAR CELL MODULE WITH LAYERS OF DESIGN FOR INTEGRATION INTO BUILDINGS**
SOLARZELLENMODUL MIT SCHICHTEN MIT ENTWURF FÜR INTEGRATION IN GEBÄUDE
MODULE DE CELLULE SOLAIRE COMPORTANT DES COUCHES CONÇUES POUR UNE INTÉGRATION DANS DES BÂTIMENTS

(30) Priority: 03.04.2009 KR 20090028771
(43) Date of publication of application: 08.02.2012
(73) Proprietor: LG Hausys, Ltd., Seoul 150-721 (KR)
(72) Inventor: YU, Je-Min, Daejeon 305-752 (KR); NO, Dong-Hun, 305-301361-302 (KR); JANG, Dong-Sik, Busan 619-734 (KR)
(74) Representative: Hoffmann Eitle
(86) International application number: PCT/KR2009/003749
(87) International publication number: WO 2010/114196

(56) References cited:
- WO-A1-01/75377
- WO-A1-2008/096711
- KR-A- 20050 068 891
- KR-A- 20060 113 710
- KR-B1- 100 858 475
- KR-B1- 100 858 475
- US-A1- 2001 047 819
- US-A1- 2003 010 378
- US-A1- 2006 225 778
- US-A1- 2008 107 799

## Description

### [Technical Field]

The present invention relates to a solar cell module for integration into buildings, and particularly to a solar cell module for integration into buildings, which is provided with layers of design so as to provide a differentiated design service.

### [Background Art]

Generally, a solar cell is a semiconductor device which converts light energy into electric energy using the photoelectric effect. The solar cell includes two semiconductor thin films having positive and negative polarities. The multiple solar cells are connected in series or parallel in order to generate desired voltage and current required by a user, so that the user can utilize power generated from the solar cells. The solar cell is a pollution-free alternative energy resource which does not use fossil fuels but uses only solar heat.

One unit cell of the solar cell generates a very small voltage of about 0.5V and is easily affected by the external environment. Therefore, the unit cell is packaged into a module, and multiple modules connected with each other according to application purposes form a solar cell array. Typically, a bulk-type cell is formed into a module of which upper and lower portions is covered or protected in the same way. A thin film cell is formed into a module including a substrate.

The module is generally comprised of a cell, a surface member, a filler, a black sheet, a sealant and a frame member. Whiteboard tempered glass is used as the surface member in order to extend the life span thereof. Recently, EVA(Ethylene Vinyl Acetate) is mainly used as the filling material, and PVF(Poly Vinyl Fluoride) is mainly used as the black sheet material. Other materials such as polyester and acryl may be also used as the black sheet material, and the black sheet member is covered by aluminum foil or polyester in order to improve moisture resistance. The sealant is used to treat an entrance of a lid portion or an end face of the module, and butyl rubber out of a group of silicon sealant, polyurethane, polysulfide and butyl rubber is frequently used as the sealant. Typically, surface oxidized aluminum is used as a panel material, and rubber may be used.

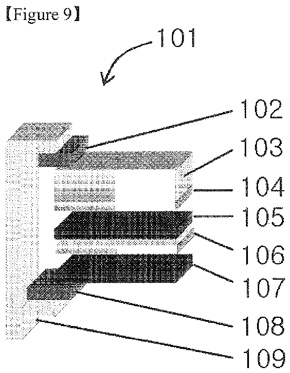

Fig. 9 shows the configuration of a conventional solar cell module. The solar cell module 101 is supported by a frame 109, and comprised of an upper rubber profile 102, a tempered glass panel 103, an upper EVA film 104, a cell 105, a lower EVA film 106, a back sheet 107 and a lower rubber profile 108.

The rubber profile 102, 108 as the sealant is made of rubber. The tempered glass panel 103 as the surface member functions to protect the cell 105 from external shock. The EVA film 104, 106 as the filler is a vinyl film made of a copolymer of ethylene and vinyl acetate and having excellent transparency, shock absorbing ability, elasticity and tensile strength. The cell 105 functions to convert light energy into electric energy. Multiple cells are arranged in series or parallel by conductive ribbon. The back sheet 107 has waterproofing, insulating and UV protecting functions and is made of PVF, polyester, acryl and the like. The frame 109 made of aluminum and the like functions to support each element of the module 101.

The conventional solar cell module is comprised of the tempered glass panel, the EVA film, the cell, the EVA film and the back sheet, when seeing from an upper side thereof. The design of the module is determined by colors of the cell and back sheet and arrangement of the cell. However, due to structural limitations, the solar cell module has a simple and monotonous design, and thus it is difficult to provide a differentiated design service.

A conventional glass-glass (G-G) type solar cell module is comprised of the tempered glass panel, the EVA film, the cell, the EVA film and the tempered glass panel, when seeing from an upper side thereof. The design of the module is determined by colors of the cell and back sheet and arrangement of the cell. However, due to structural limitations, the solar cell module has a simple and monotonous design, and thus it is also difficult to provide the differentiated design service.

A BIPV(Building Integrated Photo Voltaic) module is designed as a part of a building from an early state of building design so as to be integrated with the building (integration into buildings). Since the BIPV module is used as an exterior material for buildings, it is possible to reduce the corresponding cost. Further, since it can be harmonized with buildings, it is possible to increase an additional value of buildings. However, there are also some disadvantages in that it is necessary to concern some conditions such as temperature and it can be applied only to a new building or only when largely remodeling an existing building.

A PVIB(Photo Voltaic In Building) module is not designed essentially as a part of a building from then early state of building design, but attached or installed to the building after the building is completely constructed. In this module, it is relatively facile to perform its installation, and it can be applied to both of new and existing buildings. However, there are also some disadvantages in that it is necessary to provide a separate supporting structure and it may be not harmonized with the building to be installed.

A crystalline PV (including BIPV) module system is generally set so that it has optimum efficiency when being exposed to direct sunlight. Due to the nature of the solar cell, the efficiency thereof may be largely changed according to an incident angle of light and a light intensity. In order to maximize the efficiency with respect to the incident angle, there has been proposed a method which is provided with a sun tracking system so as to maintain an optimal azimuth angle. However, in order to use the sun tracking system, it is necessary to overcome disadvantages in a structure of the building and a cost thereof.

Korean Patent Laid-Open No.2003-81662 discloses a solar cell with a double-layer antireflection film. Herein, a cell substrate has a concavo-convex structure having regular inverted pyramid patterns. However, it pertains to the concavo-convex structure formed on a surface of the cell, not tempered glass.

Korean Patent No.359846 discloses a solar cell module as a construction material, and Korean Patent No.680654 discloses a solar cell module with an integrated light emitting device. However, due to structural limitations, the solar cell modules have a simple and monotonous design, and it is also difficult to provide a differentiated design service.

US 2001/047819 A1 discloses a solar cell module for integration into buildings comprising the preamble of claim 1.

Meanwhile, a cold facade has been used in order to use the solar cell as a solar cell module for integration into buildings. The term "facade" refers to the front of the building. Because the façade of a building has a big effect on the first impression of the building, it is a current trend to apply a glass façade as a construction material at a front surface of the building. Recently, a warm façade using a solar cell module is required to obtain durability, thermal insulation effect and alternative energy.

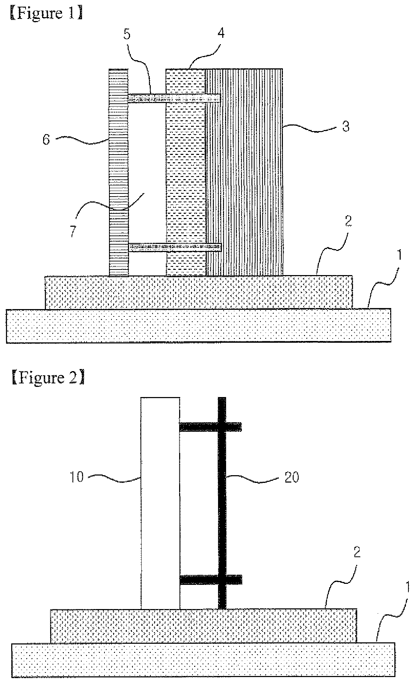

Fig. 1 is a cross-sectional view of an example of a conventional cold facade. The cold facade has a double-layered wall structure including an internal wall and an external wall. The internal wall 3 is fixed to a base member 2 formed of concrete placed on the ground 1so as to support the building on the ground 1. An insulation member 4 is provided at an outside of the internal wall 3, and a support 5 is formed at upper and lower sides of the internal wall 3 so that the external wall 6 including a solar cell for decoration can be fixed to the internal wall 3 through the support 5.

Further, an air layer is formed between the insulation member 4 and the external wall 6 so as to allow ventilation with the outside, thereby minimizing power reduction due to temperature of the module.

However, in such a method, since it is hassle to perform the installing operation and it is necessary to separately install the internal wall 3 and the insulation member 4, it would cost much.

Furthermore, in order to use the existing cold façade as an exterior material for buildings, a double insulation wall has to be additionally provided for wiring and blocking of temperature of outer air. Moreover, since the cold façade blocks penetration of light, it is structurally unsuitable to use it.

Thus, a solar cell module for integration into buildings is required, which can be easily installed, can provide various design patterns and can be used as an exterior material for the buildings.

US 2001/0047819 A1 relates to a solar battery module. In the solar battery module, a transparent EVA, a film, an EVA and a glass are sequentially stacked on a solar cell portion. The film has a printed matter in a desired pattern, which can be seen from the back side of the solar battery module through the glass on the side opposite the light incident side of the solar cell portion.

### [Disclosure]

### [Technical Problem]

An object of the present invention is to provide a solar cell module for integration into buildings, which can apply various design patterns to a double glass module including internal and external tempered glass panels, thereby improving outer appearance of the buildings and providing a differentiated design service.

Further, another object of the present invention is to provide a solar cell module for integration into buildings, which can improve energy efficiency.

Yet another object of the present invention is to provide a solar cell module for integration into buildings, which can provide an awning effect according to an injection degree of glass ink.

Yet another object of the present invention is to provide a solar cell module for integration into buildings, which can provide thermal insulating and noise preventing effect by the double glass module including internal and external tempered glass panels

Yet another object of the present invention is to provide a solar cell module for integration into buildings, of which the double glass module can be directly used as an external wall of the buildings without installing a separate external wall of the buildings.

Yet another object of the present invention is to provide a solar cell module for integration into buildings, which uses a double sealing system including TPS (Thermo Plastic System), thereby providing excellent thermal insulating ability and wind pressure resistance.

### [Technical Solution]

To achieve the object of the present invention, the present invention provides a solar cell module for integration into buildings as defined in claim 1, including external and internal tempered glass panels which are used as external walls of the buildings having a steel frame structure; and a double glass module which is disposed between the external and internal tempered glass panels, wherein the double glass module is comprised in turn of a first ethylene vinyl acetate film, a cell, a second ethylene vinyl acetate film and a glass ink coated layer.

The glass ink coated layer is formed by screen-printing a desired design pattern on a surface of the internal tempered glass panel through a spraying operation using glass ink and then heat-curing the design pattern at a temperature of 500 to 800 °C so that the glass ink is fused into and attached to the surface of the internal tempered glass panel.

In the solar cell module of the present invention, at least one of the external and internal tempered glass panels is a refractive tempered glass panel, the panel having a surface with a concavo-convex structure.

The concavo-convex structure has a triangular shape in section, and a front corner angle of the triangular shape is 50 to 60 degrees.

An edge portion between the external and internal tempered glass panels is sealed with a sealant, and
the sealant comprises a first sealant formed of BU-TPS containing an isobutylene polymer and a thermoplastic polymer, and a second sealant which is applied to an outside portion of the first sealant and formed of Thiokol.

Preferably, the concavo-convex structure is also formed on a surface of the cell, and the concavo-convex structures of the cell and the refractive tempered glass panel are coincided with each other.

Preferably, a junction box and a cable are installed at the double glass module. Preferably, the double glass module is vertically disposed on a base member and supported by a supporting frame.

### [Advantageous Effects]

According to the present invention as described above, since the solar cell module for integration into buildings of the present invention, which can be used as an exterior material for the buildings, has the design elements, it is possible to maximize an exterior effect and also to produce high value modules. And in case of the reflective design sheet, it is possible to prevent temperature rise and to increase the efficiency by reflecting sunlight.

Further, by using the refractive tempered glass panel, it is possible to always allow the light to be vertically incident to the cell, thereby increasing the energy efficiency, and thus it is possible to produce more electricity.

Further, since various design patterns can be applied to the double glass module including the external and internal tempered glass panels, it is possible to improve the appearance of the buildings and to provide the awning effect according to an injection degree of glass ink. And it is also possible to provide thermal insulating and noise preventing effects by using the double glass module including the external and internal tempered glass panels. Since the double glass module is directly applied to the external wall of the buildings, it can be facilely disposed at the buildings without installing separate internal walls.

In addition, since the double sealing system including TPS(Thermo Plastic System) is used, it is possible to provide excellent thermal insulating ability, dew condensation preventing ability, moisture absorbing ability and wind pressure resistance, and it is possible to improve the production speed and product quality and also to provide clear and various appearances.

### [Description of Drawings]

The above and other objects, features and advantages of the present invention will become apparent from the following description of preferred embodiments given in conjunction with the accompanying drawings, in which:
Fig. 1 is a cross-sectional view of a conventional cold façade.
Fig. 2 is a cross-sectional view showing a state that a solar cell module for integration into buildings is installed in a warm facade manner according to an embodiment of the present invention.
Fig. 3 is a cross-sectional view of a double glass module according to a first illustrative example.
Fig. 4 is a cross-sectional view of a double glass module according to a second illustrative example.
Fig. 5 is a cross-sectional view of a double glass module according to a third illustrative example.
Fig. 6 is a cross-sectional view of a double glass module according to an embodiment of the present invention.
Fig. 7 is a cross-sectional view showing a state that a sealant and a junction box are installed at the double glass module according to a first embodiment of the present invention.
Fig. 8 is a cross-sectional view showing light incident efficiency of a refractive tempered glass panel according to an embodiment of the present invention.
Fig. 9 is a view showing the configuration of a conventional solar cell.

**[Detailed Description of Main Elements]**

| | |
|---|---|
| 1: ground | 2: base member |
| 10: double glass module | 11: external tempered glass panel |
| 12: first EVA film | 13: cell |
| 14: second EVA film | 15a: opaque design sheet |
| 15b: semitransparent design sheet | 15c: reflective design sheet |
| 15d: glass ink coated layer | 16: third EVA film |
| 17: back sheet | 18: internal tempered glass panel |
| 19a: first sealant | 19b: second sealant |
| 20: supporting frame | 20: junction box |
| 31: cable | |

### [Best Mode]

Hereinafter, the embodiments of the present invention as well as illustrative examples, not forming part of the claimed invention, but useful for understanding the invention, will be described in detail with reference to accompanying drawings.

Fig. 2 is a cross-sectional view showing a state that a solar cell module for integration into buildings is installed in a warm facade manner according to an embodiment of the present invention. A double glass module 10 is directly installed at an external wall of a building (not shown).

In the double glass module 10, a separate internal tempered glass 18 is disposed inside an external tempered glass in order to improve durability and insulation performance thereof. The double glass module 10 is disposed to be vertical to the ground 1 and a base member 2 such as concrete placed on the ground 1. Upper and lower sides of a supporting means such as a supporting frame 20 are attached to other side surface of the internal tempered glass panel 18, and a lower end of the supporting means is attached to the base member 2 so as to support the double glass module 10.

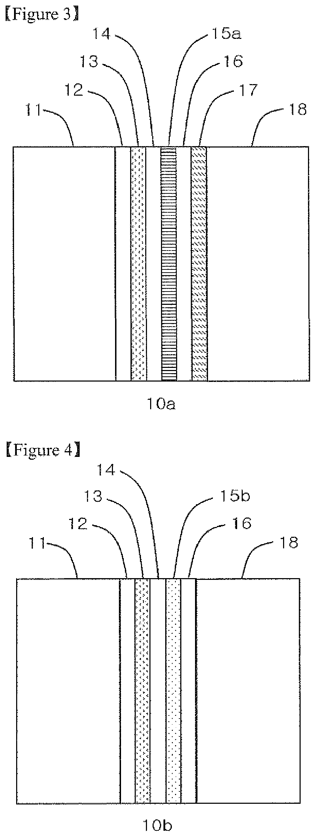

Fig. 3 is a cross-sectional view of a double glass module according to a first illustrative example. The double glass module 10a is comprised of an external tempered glass panel 11, a first EVA film 12, a cell 13, a second EVA film 14, an opaque design sheet 15a, a third EVA film 16, a back sheet 17 and an internal tempered glass panel 18, when seeing from a left side thereof.

The internal and external tempered glass panels 11 and 18 directly serve as external walls of the buildings and also function to protect the cell 13 from external shock and the like.

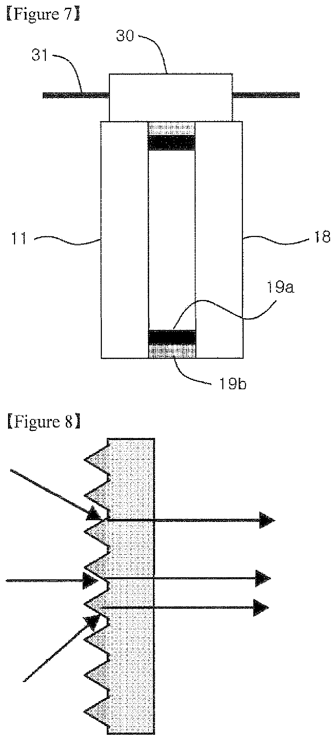

The internal and external tempered glass panels 11 and 18 may be a flat tempered glass panel or a refractive tempered glass panel shown in Fig. 8.

A concavo-convex structure is formed on a surface of the refractive tempered glass panel. Preferably, the concavo-convex structure has a triangular shape in section in order to obtain the optimal efficiency of incident angle. An angle of the concavo-convex structure is more important than a width or depth thereof, and the angle is preferably 50 to 60 degrees based on a front corner angle of the triangular shape.

The refractive tempered glass panel used in the invention is manufactured by etching a tempered glass panel so that the concavo-convex structure is formed thereon. Glass etching is more facile, efficient and cheaper than cell etching.

The concavo-convex structure is formed by etching a tempered glass panel using laser, chemicals and the like. Like a prism film for notebook computers, the etching process has to be minutely performed within an extent that the human body is not harmed by an etched surface. And it should be also prevented that a top portion of an etched layer is excessively protruded and thus worn.

The first, second and third EVA films 12, 14 and 16 function as the filler and attaching means, and they are a vinyl film made of a copolymer of ethylene and vinyl acetate and having excellent transparency, shock absorbing ability, elasticity and tensile strength. Further, since the vinyl film has high gas barrier ability, excellent organic solvent ability and workability, it is facile to perform a thermo forming operation.

The cell 13 functions to convert light energy into electric energy, and multiple cells are arranged in series or parallel by conductive ribbon.

Preferably, the cell 13 also has the concavo-convex structure corresponding to that of the refractive tempered glass panel. Therefore, it is possible to maximize the energy efficiency due to the synergy between the concavo-convex structures.

In the opaque design sheet 15a, a design pattern is formed on various sheets such as paper, fiber sheet, synthetic resin sheet, metal sheet, inorganic sheet, woody sheet, glass sheet and leather sheet using various methods such as printing, coating, lapping, deposition, sputtering, painting, plating, impregnation and etching.

The back sheet 17 has waterproofing, insulating and UV protecting functions and is made of PVF, polyester, acryl and the like. The back sheet 17 may be a sheet in which fluoro resin having higher weather resistance than the existing PVF film is coated with a polyethylene terephthalate (PET), thereby providing excellent long durability, vapor blocking ability, electric insulating ability and adhesive property with a sealant.

Fig. 4 is a cross-sectional view of a double glass module according to a second illustrative example. The double glass module 10b is comprised of an external tempered glass panel 11, a first EVA film 12, a cell 13, a second EVA film 14, a semitransparent design sheet 15b, a third EVA film 16 and an internal tempered glass panel 18, when seeing from a left side thereof. In the embodiment, it is possible to provide a lighting effect by using the semitransparent design sheet 15b.

In the semitransparent design sheet 15b, a design pattern is formed on various sheets such as paper, fiber sheet, synthetic resin sheet, metal sheet, inorganic sheet, woody sheet, glass sheet and leather sheet using various methods such as printing, coating, lapping, deposition, sputtering, painting, plating, impregnation and etching.

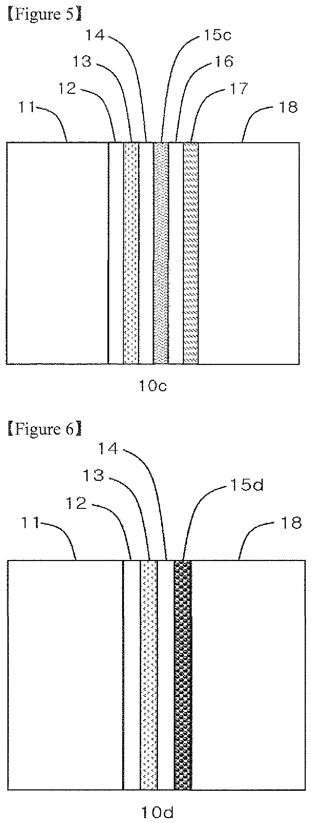

Fig. 5 is a cross-sectional view of a double glass module according to a third illustrative example. The double glass module 10c is comprised of an external tempered glass panel 11, a first EVA film 12, a cell 13, a second EVA film 14, a reflective design sheet 15c, a third EVA film 16, a back sheet 17 and an internal tempered glass panel 18, when seeing from a left side thereof. In the embodiment, it is possible to increase energy efficiency and to prevent temperature-rise by reflecting sunlight.

In the reflective design sheet 15c, a design pattern is formed on various sheets such as paper, fiber sheet, synthetic resin sheet, metal sheet, inorganic sheet, woody sheet, glass sheet and leather sheet using various methods such as printing, coating, lapping, deposition, sputtering, painting, plating, impregnation and etching. For example, the sheet may be a metallic reflective sheet like aluminum foil, polymer reflective sheet and retroreflective sheet.

Fig. 6 is a cross-sectional view of a double glass module according to an embodiment of the present invention. The double glass module 10d is comprised of an external tempered glass panel 11, a first EVA film 12, a cell 13, a second EVA film 14, a glass ink coated layer 15d and an internal tempered glass panel 18, when seeing from a left side thereof.

In the glass ink coated layer 15d, a desired design pattern is screen-printed on a surface of the internal tempered glass panel 18 through a spraying operation using glass ink, and then preferably heat-cured at a temperature of 500 to 800 °C so that the glass ink is fused into and attached to the surface of the internal tempered glass panel 18.

Since the glass ink coated layer 15d is not deteriorated and discolored, it can be used permanently. Further, by using the glass ink as well as the solar cell pattern, various design patterns can be provided over the entire surface of the internal tempered glass panel 128 of the double glass module 10, thereby providing various appearances of the buildings.

Fig. 7 is a cross-sectional view showing a state that a sealant and a junction box are installed at the double glass module according to the first illustrative example. Edge portions between the internal and external tempered glass panels 11 and 18 are treated by a sealant 19a, 19b so as to maintain airtightness therebetween.

The sealant 19a, 19b may typically be a silicon-based sealant, and preferably a double sealing system including a first sealant 19a formed of TPS and a second sealant 19b formed of Thiokol.

The first sealant 19a is comprised of a sealing composition containing a base polymer and a selected additional component.

The base polymer may be comprised of an isobutylene homopolymer, copolymer, trimer, or a compound thereof; or an acrylate and/or methacrylate monopolyer and/or copolymer or a compound thereof.

The additional component may be a thermoplastic polymer, natural and synthetic rubber, an adhesion-imparting additive, a plasticizer, a binder, a reinforcing and non-reinforcing filler, a stabilizer and other additive.

For example, the thermoplastic polymer may be polyolefin polymer and copolymer. The thermoplastic polymer may be synthesized from ethylene, propylene and n-butene monomer, a higher homologue thereof, and an isomer thereof, and also synthesized from functional vinyl compound such as vinyl acetate, vinyl chloride, styrene and α-methylstyrene. In addition, the thermoplastic polymer may be polyamide, polyimide, polyacetal, polycarbonate, polyester, polyurethane and the like.

Preferably, the first sealant 19a is formed of BU-TPS (e.g., Naftotherm BU-TPS prepared by chemetal company, German) as an edge sealing compound based on an isobutylene polymer, which contains a thermoplastic polymer so as to provide permanent flexibility.

The first sealant 19a may contain moisture absorbent such as zeolite.

Preferably, the second sealant 19b is formed of Thiokol. The Thiokol is a proprietary name for polysulfide rubber prepared by Thiokol Chemical Co., USA. The Thiokol is prepared by a condensation reaction of alkali polysulfide and an organic compound having a halogen group at both ends thereof.

In case of a general double (multi-layered) glass panel, the edge sealing system is comprised of an aluminum space, a moisture absorbent filled in the spacer, an internal sealant made of butyl (a non-curing sealant based on polyisobutylene), which is attached to both outer surfaces of the spacer, and an external sealant formed of Thiokol and the like.

In the general double glass panel, there are some problems in that a lot of gas is leaked when manufacturing argon gas glass, production speed is reduced and many (at least four or more) laborers are required due to its manual operation, heat loss is increased and dew condensation occurs frequently due to its aluminum material, and its structural strength is deteriorated due to the metal spacer. Further, product quality may be deteriorated due to a number of manual processes, and an amount of the applied moisture absorbent is changed according to laborers and thus quality defect may occur and the moisture absorbing ability is also deteriorated. Moreover, a sealing line may be uneven or cut off, and also the product quality is considerably deteriorated at a curved portion of the sealing line.

In the TPS edge sealing system used in the present invention, three functions of the conventional aluminum spacer, the moisture absorbent and the internal sealant made of butyl are combined into one, high quality of glass product can be achieved due to a low gas leakage rate, it is possible to achieve high production speed and the small number of laborers (about one laborer) and to maintain the high quality of the product, due to its automatic operation, the heat loss is minimized due to its non-metallic material, the dew condensation is reduced due to reduction in heat conduction, and its structural strength is increased due to absorbing of shock. Further, due to the automatic operation, the close contacting ability is improved, the amount of the moisture absorbent is constant since the moisture absorbent can be constantly distributed in TPS, thereby providing the uniform moisture absorbing ability, the sealing line is clear and uniform even at the curved portion thereof, and thus it is possible to produce various glass panels having various shapes. Furthermore, it is possible to facilely control a gap between the glass panels, to easily fabricate the double glass panel having various shapes with the same quality, and also to fabricate open type double glass and latticed window. In addition, due to excellent elasticity and elastic recovery, it has high durability against pressure, it is free from shearing stress generated by its relaxation and contraction motion, and it has also high durability against temperature and wind pressure due to flexibility of RPS.

As shown in Fig. 7, a cable 31 and a junction box 30 are disposed at an upper center portion of the double glass module 10. Before using the double glass module 10, the junction box 30 is attached to an upper portion of the double glass module 10 and the cable 31 is connected. A ribbon (not shown) for connecting multiple solar cells is connected to the cable.

Fig. 8 is a cross-sectional view showing light incident efficiency of a refractive tempered glass panel according to an embodiment of the present invention. Even though light is incident in any directions, the light is allowed to be vertically incident to the cell through the refractive tempered glass panel for optimizing refraction of light, thereby optimizing an incident angle of the light.

### [First embodiment]

As shown in Fig. 2, after a base member 2 is formed by placing concrete on the ground 1, a double glass module 10 is vertically installed on the base member 2 and then supported by a supporting frame 20 formed of a metallic material.

As shown in Fig. 6, the double glass module 10 is comprised of an external tempered glass panel 11, a first EVA film 12, a cell 13, a second EVA film 14, a glass ink coated layer 15c and an internal tempered glass panel 18, when seeing from a left side thereof.

The external and internal tempered glass panels 11 and 18 are formed of tempered glass.

The first and second EVA films 12 and 14 are an EVA film.

The cell 13 is a typical silicon semiconductor cell.

In the glass ink coated layer 15d, a desired design pattern is screen-printed on a surface of the internal tempered glass panel 18 using glass ink and then heat-cured at a temperature of 650 °C.

Further, edge portions between the internal and external tempered glass panels 11 and 18 are treated by a sealant 19a, 19b. The first sealant 19a is TPS and the second sealant 19b is Thiokol.

### [Second embodiment]

The second embodiment is the same as the first embodiment except that a refractive tempered glass panel having a triangular concavo-convex structure is used as the external and internal tempered glass panels 11 and 18 and a front corner angle of the triangle is 55 degrees, as shown in Fig. 8.

### [Comparative example]

A sealant comprised of an aluminum spacer, moisture absorbent and butyl is used instead of the first sealant 19a of the first embodiment.

### [Test example]

Physical properties are measured in each solar cell module of the embodiments and the comparative example, and results thereof are indicated in tables 1 and 2.

**Table 1**

| | First embodiment | Comparative example |
|---|---|---|
| Total resistance of heat transmission | 0.661m²K/W | 0.356m²K/W |
| Adiabatic exponent | 185 | 100 |
| Dew condensation (temperature of internal glass panel) | 16.2°C | 13°C |
| Heat conductivity | 0.053 W/mK | 0.108W/mK |
| Pressure resistance (24hours, load of 200kg) | No changing in thickness | Reduction in thickness of 7.1% |
| Pressure resistance (90°C, load of 10kg, 14days) | No changing | Reduction in butyl |

As described in table 1, thermal insulation performance in the embodiment is increased by 85% compared with the comparative example, and temperature of the internal glass panel in the embodiment is improved by 3.2°C compared with the comparative example, and the dew condensation is remarkably improved, and also the embodiment has more excellent pressure resistance (high load and temperature).

**Table 2**

| | Energy efficiency |
|---|---|
| Second embodiment | 3% increase compared with first embodiment |

As described in table 2, energy efficiency in the second embodiment using the refractive tempered glass panel is increased by 3% based on that in the first embodiment.

### [Industrial Applicability]

According to the present invention as described above, since the solar cell module for integration into buildings of the present invention, which can be used as an exterior material for the buildings, has the design elements, it is possible to maximize an exterior effect and also to produce high value modules. And in case of the reflective design sheet, it is possible to prevent temperature rise and to increase the efficiency by reflecting sunlight.

Further, by using the refractive tempered glass panel, it is possible to always allow the light to be vertically incident to the cell, thereby increasing the energy efficiency, and thus it is possible to produce more electricity.

Further, since various design patterns can be applied to the double glass module including the external and internal tempered glass panels, it is possible to improve the appearance of the buildings and to provide the awning effect according to an injection degree of glass ink. And it is also possible to provide thermal insulating and noise preventing effects by using the double glass module including the external and internal tempered glass panels. Since the double glass module is directly applied to the external wall of the buildings, it can be facilely disposed at the buildings without installing separate internal walls.

In addition, since the double sealing system including TPS(Thermo Plastic System) is used, it is possible to provide excellent thermal insulating ability, dew condensation preventing ability, moisture absorbing ability and wind pressure resistance, and it is possible to improve the production speed and product quality and also to provide clear and various appearances.

## Claims

1. A solar cell module for integration into buildings, comprising: an external glass panel (11) and an internal glass panel (18) which are used as external walls of the buildings; and
a double glass module (10) which is disposed between the external and internal glass panels (11, 18),
**characterized in that** the external and internal glass panels (11, 18) are tempered glass panels;
wherein the double glass module (10) is comprised of a first ethylene vinyl acetate film (12), a cell (13), a second ethylene vinyl acetate film (14) and a glass ink coated layer (15d); and
wherein at least one of the external and internal tempered glass panels (11, 18) is a refractive tempered glass panel, the panel having a surface with a concavo-convex structure,
wherein the glass ink coated layer (15d) is formed by screen-printing a desired design pattern on a surface of the internal tempered glass panel (18) through a spraying operation using glass ink and then heat-curing the design pattern at a temperature of 500 to 800°C so that the glass ink is fused into and attached to the surface of the internal tempered glass panel (18),
wherein the concavo-convex structure has a triangular shape in section, and a front corner angle of the triangular shape is 50 to 60 degrees,
wherein an edge portion between the external and internal tempered glass panels (11, 18) is sealed with a sealant (19a, 19b), and
wherein the sealant (19a, 19b) comprises a first sealant (19a) formed of BU-TPS containing an isobutylene polymer and a thermoplastic polymer, and a second sealant (19b) which is applied to an outside portion of the first sealant and formed of Thiokol.

2. The solar cell module according to claim 1, wherein a concavo-convex structure is also formed on a surface of the cell, and the concavo-convex structure of the cell and the refractive tempered glass panel are coincided with each other.

3. The solar cell module according to claim 1, wherein a junction box (20) and a cable (31) are installed at the double glass module (10).

4. The solar cell module according to claim 1, wherein the double glass module (10) is vertically disposed on a base member (2) and supported by a supporting frame (20).

## Patentansprüche

1. Solarzellenmodul für die Integration in Gebäude, umfassend:
eine externe Glasscheibe (11) und eine interne Glasscheibe (18), die als externe Wände der Gebäude verwendet werden; und
ein Doppelglasmodul (10), das zwischen den externen und den internen Glasscheiben (11, 18) angeordnet ist,
**dadurch gekennzeichnet, dass** die externen und internen Glasscheiben (11, 18) gehärtete Glasscheiben sind;
wobei das Doppelglasmodul (10) aus einem ersten Ethylenvinylacetatfilm (12), einer Zelle (13), einem zweiten Ethylenvinylacetatfilm (14) und einer mit Glastinte beschichteten Schicht (15d) besteht; und
wobei mindestens eine der externen und internen gehärteten Glasscheiben (11, 18) eine refraktive gehärtete Glasscheibe ist, wobei die Scheibe eine Oberfläche mit einer konkav-konvexen Struktur aufweist,
wobei die mit Glastinte beschichtete Schicht (15d) durch Siebdrucken eines gewünschten Entwurfsmusters auf eine Oberfläche der internen gehärteten Glasscheibe (18) durch einen Sprühvorgang unter Verwendung von Glastinte und anschließendes Wärmehärten des Entwurfsmusters bei einer Temperatur von 500 bis 800 °C gebildet wird, so dass die Glastinte in die Oberfläche der internen gehärteten Glasscheibe (18) eingeschmolzen und an dieser befestigt wird,
wobei die konkav-konvexe Struktur im Querschnitt eine dreieckige Form aufweist und ein vorderer Eckwinkel der dreieckigen Form 50 bis 60 Grad beträgt,
wobei ein Randabschnitt zwischen den externen und internen gehärteten Glasscheiben (11, 18) mit einem Dichtmittel (19a, 19b) abgedichtet ist und
wobei das Dichtmittel (19a, 19b) ein erstes Dichtmittel (19a), das aus BU-TPS gebildet ist, das ein Isobutylenpolymer und ein thermoplastisches Polymer enthält, und ein zweites Dichtmittel (19b), das auf einen äußeren Abschnitt des ersten Dichtmittels aufgetragen wird und aus Thiokol gebildet ist, umfasst.

2. Solarzellenmodul nach Anspruch 1, wobei eine konkav-konvexe Struktur auch auf einer Oberfläche der Zelle gebildet ist, und die konkav-konvexe Struktur der Zelle und der refraktiven gehärteten Glasscheibe in Übereinstimmung miteinander gebracht werden.

3. Solarzellenmodul nach Anspruch 1, wobei eine Anschlussdose (20) und ein Kabel (31) an dem Doppelglasmodul (10) installiert sind.

4. Solarzellenmodul nach Anspruch 1, wobei das Doppelglasmodul (10) vertikal auf einem Basiselement (2) angeordnet ist und von einem Stützrahmen (20) gestützt wird.

## Revendications

1. Module de cellule solaire conçu pour une intégration dans des bâtiments, comprenant:
un panneau de verre externe (11) et un panneau de verre interne (18) qui sont utilisés comme parois externes des bâtiments ; et
un module de verre double (10) qui est disposé entre les panneaux de verre externe et interne (11, 18),
**caractérisé en ce que** les panneaux de verre externe et interne (11, 18) sont des panneaux de verre trempé ;
dans lequel le module de verre double (10) est composé d'un premier film d'éthylène-acétate de vinyle (12), d'une cellule (13), d'un second film d'éthylène-acétate de vinyle (14) et d'une couche revêtue d'encre pour verre (15d) ; et
dans lequel au moins un des panneaux de verre trempé externe et interne (11, 18) est un panneau de verre trempé réfractif, le panneau présentant une surface avec une structure concavo-convexe,
dans lequel la couche revêtue d'encre pour verre (15d) est formée par sérigraphie d'un motif de conception souhaité sur une surface du panneau de verre trempé interne (18) par le biais d'une opération de pulvérisation au moyen d'encre pour verre et puis de thermodurcissement du motif souhaité à une température de 500 à 800 °C de sorte que l'encre pour verre est fusionnée dans et fixée à la surface du panneau de verre trempé interne (18),
dans lequel la structure concavo-convexe présente une forme triangulaire en coupe, et un angle de coin avant de la forme triangulaire fait 50 à 60 degrés,
dans lequel une partie de bord entre les panneaux de verre trempé externe et interne (11, 18) est scellée avec un agent d'étanchéité (19a, 19b), et
dans lequel l'agent d'étanchéité (19a, 19b) comprend un premier agent d'étanchéité (19a) formé de BU-TPS contenant un polymère d'isobutylène et un polymère thermoplastique, et un second agent d'étanchéité (19b) qui est appliqué à une partie extérieure du premier agent d'étanchéité et formé de Thiokol.

2. Module de cellule solaire selon la revendication 1, dans lequel une structure concavo-convexe est également formée sur une surface de la cellule, et la structure concavo-convexe de la cellule et le panneau de verre trempé réfractif coïncident l'un avec l'autre.

3. Module de cellule solaire selon la revendication 1, dans lequel un boîtier de jonction (20) et un câble (31) sont installés au niveau du module de verre double (10).

4. Module de cellule solaire selon la revendication 1, dans lequel le module de verre double (10) est disposé verticalement sur un élément de base (2) et supporté par un cadre de support (20).
